# EUROPÄISCHE PATENTANMELDUNG

(11) **EP 4 567 513 A2**
(43) Veröffentlichungstag der Anmeldung: **11.06.2025**
(21) Anmeldenummer: 24209862.2
(22) Anmeldetag: 30.10.2024
(51) Int. Cl.: G03F 1/84

(54) **OPTISCHE INSPEKTIONSVORRICHTUNG**

(30) Priorität: 09.11.2023 DE 102023131119
(71) Anmelder: Carl Zeiss SMT GmbH, 73447 Oberkochen (DE)
(72) Erfinder: HENNING, Maximilian, 73447 Oberkochen (DE)
(74) Vertreter: Raunecker, Klaus Peter

(57) **Zusammenfassung**

Die Erfindung betrifft eine optische Inspektionsvorrichtung (100) für Elemente (1) der Halbleiterlithographie, mit einer in einem ersten Teilvolumen (4) angeordneten Abbildungsvorrichtung (2) zur Erzeugung eines Bildes eines Elementes (1) und einem zweiten Teilvolumen (5), welches eine Haltevorrichtung (20) zur Aufnahme des Elementes (1) umfasst. Dabei ist zwischen den beiden Teilvolumina (4,5) ein Trennelement (11) angeordnet. Weiterhin ist eine Positionsmessvorrichtung (7) zur Ermittlung der Position und Ausrichtung der Abbildungsvorrichtung (2) und der Haltevorrichtung (20), vorhanden, wobei die Positionsmessvorrichtung (7) Referenzmarken (15) zur Emission einer in der Positionsmessvorrichtung (7) verwendeten elektromagnetischen Strahlung umfasst und wobei die Referenzmarken (15) jeweils mit der Abbildungsvorrichtung (2) und der Haltevorrichtung (20) verbunden sind. Das Trennelement (11) umfasst eine Trennwand mit einer Öffnung (6), wobei die Öffnung (6) zur Bildaufnahme durch die Abbildungsvorrichtung (2) dient und wobei die von der auf der Abbildungsvorrichtung (2) angebrachten Referenzmarke (15) ausgehende und in der Positionsmessvorrichtung (7) verlaufende elektromagnetische Strahlung die Öffnung (6) durchtritt.

## Beschreibung

Die Erfindung betrifft eine optische Inspektionsvorrichtung, insbesondere ein Maskeninspektionssystem für Fotomasken der Halbleiterlithographie.

Derartige Inspektionsvorrichtungen werden eingesetzt, um den Zustand von in der Halbleiterlithographie verwendeten Fotomasken zu ermitteln; insbesondere auch um während der Produktion oder auch des Einsatzes der entsprechenden Masken aufgetretene Fehler zu identifizieren, um eine nachfolgende Reparatur einer Maske zu ermöglichen.

Üblicherweise umfasst ein derartiges System eine Abbildungsvorrichtung, welche eine auf einer Haltevorrichtung, einem sogenannten Maskenhalter, angeordnete Maske abschnittsweise, schrittweise oder auch scannend aufnimmt.

Mit der zunehmenden Verbreitung der EUV Lithographie, also einer Form von Halbleiterlithographie unter Verwendung von extrem kurzen Wellenlängen, insbesondere Wellenlängen von wenigen Nanometern, werden zur Inspektion und auch zur Handhabung der Fotomasken besondere Maßnahmen erforderlich.

Insbesondere muss die Inspektion der Masken üblicherweise in einer Vakuumumgebung erfolgen. Üblicherweise werden dabei die Abbildungsvorrichtungen und die zu untersuchenden Masken in zwei unterschiedlichen, jeweils selbstständig konditionierten Teilvolumina angeordnet, und es verbleibt zwischen den Teilvolumina lediglich eine kleine Öffnung zum Durchtritt der zur Untersuchung der Maske verwendeten elektromagnetischen Strahlung.

Für eine zuverlässige Abbildung der Maske ist es jedoch notwendig, dass die relative Position der Abbildungsvorrichtung zu der zu untersuchenden Maske möglichst exakt bekannt bzw. auch möglichst exakt schnell regelbar ist. Hierzu ist es erforderlich, die jeweiligen Positionen der beteiligten Elemente möglichst genau zu erfassen. Dabei werden typischerweise Positionsmessvorrichtungen wie beispielsweise Interferometer verwendet. In der Regel erfassen diese Positionsmessvorrichtungen die Position des Maskenhalters und damit mittelbar die Position der Maske.

Es ist in diesem Zusammenhang von Vorteil, wenn die Positionsinformationen beider vermessener Komponenten, also der Abbildungsvorrichtung wie auch der untersuchten Maske mit derselben Messvorrichtung aufgenommen werden, um eine möglichst einfache Bestimmung der relativen Position von Abbildungsvorrichtung und Maske vornehmen zu können. Diese gemeinsame Messung wird jedoch durch die Anordnung der Abbildungsvorrichtung und der Maske in unterschiedlichen Teilvolumina erschwert.

Aufgabe der vorliegenden Erfindung ist es, eine Vorrichtung anzugeben, welche eine möglichst einfache und präzise Bestimmung der relativen Position einer Abbildungsvorrichtung und einer zu untersuchenden Maske bzw. eines zu untersuchenden Elementes gewährleistet.

Diese Aufgabe wird gelöst durch eine Vorrichtung mit den Merkmalen des unabhängigen Anspruchs 1. Die Unteransprüche betreffen vorteilhafte Weiterbildungen und Varianten der Erfindung.

Eine erfindungsgemäße optische Inspektionsvorrichtung umfasst eine in einem ersten Teilvolumen angeordnete Abbildungsvorrichtung zur Erzeugung eines Bildes eines Elementes und ein zweites Teilvolumen, welches eine Haltevorrichtung zur Aufnahme des Elementes umfasst. Dabei ist zwischen den beiden Teilvolumina ein Trennelement angeordnet. Weiterhin umfasst die Inspektionsvorrichtung mindestens eine Positionsmessvorrichtung zur Ermittlung der Position und Ausrichtung der Abbildungsvorrichtung und der Haltevorrichtung, wobei die Positionsmessvorrichtung Referenzmarken zur Emission einer in der Positionsmessvorrichtung verwendeten elektromagnetischen Strahlung umfasst. Unter einer Emission ist im Sinne der vorliegenden Anmeldung insbesondere auch eine Reflexion einfallender Strahlung durch die Referenzmarken zu verstehen. Die Referenzmarken sind jeweils mit der Abbildungsvorrichtung und der Haltevorrichtung verbunden.

Dabei umfasst das Trennelement eine Trennwand mit einer Öffnung, wobei die Öffnung zur Bildaufnahme durch die Abbildungsvorrichtung dient und wobei die von der auf der Abbildungsvorrichtung angebrachten Referenzmarke ausgehende und in der Positionsmessvorrichtung verlaufende elektromagnetische Strahlung die Öffnung durchtritt.

Auf diese Weise kann die Öffnung zwischen den Teilvolumina klein gehalten werden, wodurch es erleichtert wird, unterschiedliche atmosphärische Bedingungen in den Teilvolumina aufrecht zu erhalten. Insgesamt lässt sich die Konstruktion durch die gezeigten Maßnahmen auch wesentlich kompakter ausführen und ein Tausch der Abbildungsvorrichtung im Feld, also am Einsatzort, wird vereinfacht.

In einer vorteilhaften Variante der Erfindung sind mindestens zwei Positionsmessvorrichtungen und mindestens zwei auf der Abbildungsvorrichtung angebrachte Referenzmarken vorhanden, wobei die Strahlwege der von den Referenzmarken ausgehenden und in den Positionsmessvorrichtungen verlaufenden elektromagnetischen Strahlung schräg zu einander verlaufen.

Insbesondere können sich die Strahlwege der von den Referenzmarken ausgehenden und in den Positionsmessvorrichtungen verlaufenden elektromagnetischen Strahlung kreuzen.

Bei dem Element kann es sich wie bereits erwähnt um eine Fotomaske für die Halbleiterlithographie, beispielsweise für die EUV-Lithographie handeln; insbesondere kann es sich bei der optischen Inspektionsvorrichtung um ein Maskeninspektionssystem für Fotomasken der EUV-Lithographie handeln.

Die Fotomaske kann ein Aspektverhältnis zwischen 1:1 und 1:3, vorzugsweise zwischen 1:1 und 1:2, besonders bevorzugt von 1:1 oder 1:2 aufweisen; sie kann im Wesentlichen rechteckförmig ausgestaltet sein. Die Fotomaske kann bevorzugt 5 bis 7 Inch **(12,7 bis 17,78 cm)** lang und breit sein, besonders bevorzugt 6 Inch **(15,24 cm)** lang und breit. Alternativ hierzu kann die Fotomaske 5 bis 7 Inch **(12,7 bis 17,78 cm)** breit und 10 bis 14 Inch **(25,4 bis 35,56 cm)** lang sein, vorzugsweise 6 Inch **(15,24 cm)** breit und 12 Inch **(30,48 cm)** lang.

In einer vorteilhaften Ausführungsform der Erfindung kann es sich bei der Positionsmessvorrichtung um ein Interferometer handeln.

Dabei kann das Interferometer insbesondere bei einer von der der zur Bildaufnahme verwendeten Strahlung abweichenden Wellenlänge, beispielsweise bei 200 nm bis 1700 nm, vorzugsweise 400 nm bis 800 nm arbeiten. Die von den Referenzmarken ausgehende elektromagnetische Strahlung wird in diesem Fall dadurch erzeugt, dass die Referenzmarken als Reflektoren ausgebildet sind, welche in dem Interferometer beleuchtet werden und die einfallende Strahlung in bekannter Weise im Strahlengang des Interferometers zurückreflektieren.

Weiterhin kann mindestens eine Positionsmessvorrichtung derart ausgebildet sein, dass eine von einer Referenzmarke auf der Abbildungsvorrichtung ausgehende und die Positionsmessvorrichtung erreichende elektromagnetische Strahlung in die Positionsmessvorrichtung in demjenigen Teilvolumen eintritt, in welchem auch die Abbildungsvorrichtung angeordnet ist.

In einer vorliegend nicht beanspruchten Variante der Erfindung kann mindestens eine Positionsmessvorrichtung derart ausgebildet sein, dass eine von einer Referenzmarke auf der Haltevorrichtung ausgehende und in der Positionsmessvorrichtung verlaufende elektromagnetische Strahlung vollständig in demjenigen Teilvolumen verläuft, in welchem auch die Haltevorrichtung angeordnet ist.

Die kann beispielsweise dadurch erreicht werden, dass mindestens Teile einer Positionsmessvorrichtung in das Trennelement derart eingefügt sind, dass eine Strahlungseintrittsöffnung für von einer Referenzmarke auf der Haltevorrichtung ausgehende und in der Positionsmessvorrichtung verlaufende elektromagnetische Strahlung im selben Teilvolumen angeordnet ist wie die Haltevorrichtung, wohingegen eine Strahlungseintrittsöffnung für von einer Referenzmarke auf der Abbildungsvorrichtung ausgehende und in der Positionsmessvorrichtung verlaufende elektromagnetische Strahlung im selben Teilvolumen angeordnet ist wie die Abbildungsvorrichtung.

Nachfolgend werden Ausführungsbeispiele und Varianten der Erfindung anhand der Zeichnung näher erläutert. Es zeigen
- Figur 1: Ein Maskeninspektionssystem zur Untersuchung von Fotomasken,
- Figur 2: eine Alternative zu der in Figur 1 gezeigten Anordnung,
- Figur 3: eine weitere Ausführungsform der Erfindung; und
- Figur 4: eine weitere Ausführungsform der Erfindung.

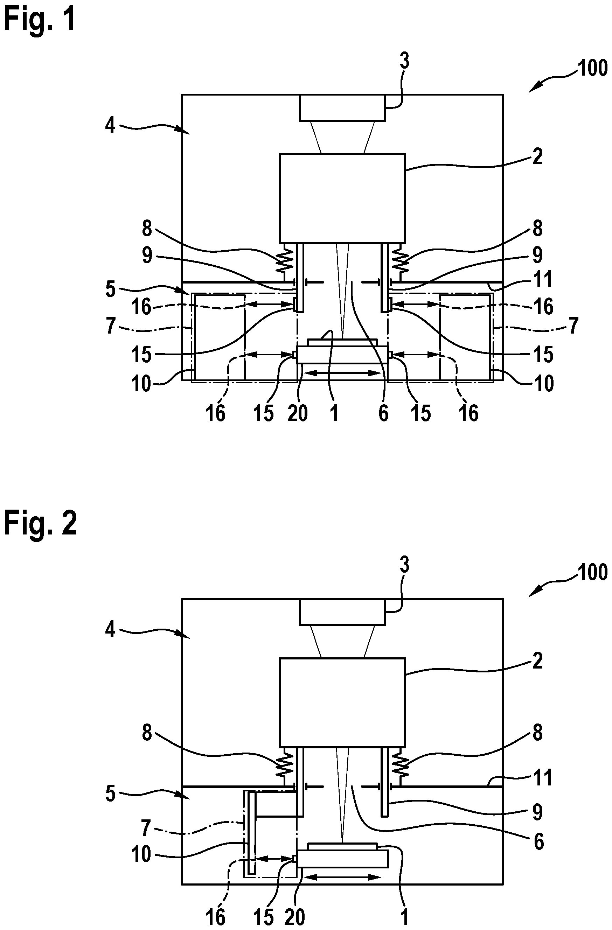

Figur 1 zeigt schematisch und auszugsweise eine vorliegend nicht beanspruchte als Maskeninspektionssystem 100 zur Untersuchung von Elementen, im gezeigten Beispiel von Fotomasken für die EUV-Lithographie, ausgebildete optische Inspektionsvorrichtung. In derartigen Systemen werden die Fotomasken - anders als in Inspektionssystemen für Masken für größere Wellenlängen - nicht ausschnittsweise und ruhend aufgenommen, sondern es wird in der Regel ein Scan der gesamten Maskenoberfläche vorgenommen. Dabei wird eine Maske 1 unter einer Abbildungsvorrichtung 2 scannend durchbewegt, was in der Figur 1 durch den nicht bezeichneten Doppelpfeil verdeutlicht ist. Die Maske 1 ist dabei auf einer verfahrbaren Haltevorrichtung 20, einem sogenannten Maskenhalter, angeordnet.

Weiterhin dargestellt in der Figur ist ein Bildsensor 3, auf welchen die Abbildungsvorrichtung 2 die Oberfläche der Maske 1 abbildet. Der Bildsensor 3 kann dabei als TDI Sensor - ähnlich den in Zeilenkameras verwendeten Sensoren - ausgebildet sein.

Die Abbildungsvorrichtung 2 und der Bildsensor 3 befinden sich dabei in einem als Vakuumkammer 4 ausgebildeten ersten Teilvolumen, wohingegen sich die auf dem Maskenhalter 20 angeordnete Maske 1 in einem weiteren als Vakuumkammer 5 ausgebildeten Teilvolumen befindet, welche von der Vakuumkammer 5 durch ein als Trennwand 11 ausgebildetes Trennelement getrennt ist. Die Vakuumkammer 5 kann - anders als dargestellt - insbesondere auch in der Form einer Box ausgebildet sein, wobei sich die Box innerhalb der Vakuumkammer 4 befinden kann. Zwischen der Abbildungsvorrichtung 2 und der Vakuumkammer 4 sind Entkopplungselemente 8 angeordnet, welche eine mindestens teilweise Entkopplung der Abbildungsvorrichtung 2 von der Vakuumkammer 4 bewirken.

Die getrennten Vakuumkammern 4 und 5 sind dabei erforderlich, um Kontaminationen so gering wie möglich zu halten; darüber hinaus sind in den Kammern 4 und 5 üblicherweise auch unterschiedliche Atmosphären bzw. Medien vorhanden. Zwischen den beiden Vakuumkammern 4 und 5 befindet sich eine Öffnung 6, durch welche das von der Maske 1 ausgehende Licht hindurchtritt und die Abbildungsvorrichtung 2 erreicht.

Durch die Scanbewegung der Maske 1, aber auch durch Umgebungseinflüsse wie Vibrationen des zugehörigen Hallenbodens oder ähnliches werden jedoch mechanische Störungen eingetragen, welche ohne weitere Maßnahmen zu einem Versatz der Abbildungsvorrichtung 2 gegenüber der Maske 1 während des Scanvorganges führen würden. Durch einen derartigen Versatz würde die Bildqualität beeinträchtigt; es ist also wünschenswert, dass auch während des Scans - von der Scanbewegung abgesehen - die Abbildungsvorrichtung 2 und die Maske 1 in einer festen räumlichen Beziehung zu einander stehen. Es ist also erforderlich, die Maske 1 der Abbildungsvorrichtung 2 nachzuführen. Hierzu müssen die Positionen der Maske 1 und der Abbildungsvorrichtung 2 in einem gemeinsamen Koordinatensystem bekannt sein. Zur Bestimmung dieser Positionen kommen als Positionsmessvorrichtungen die Interferometer 7 zur Anwendung, welche beispielsweise als Differenzialinterferometer ausgebildet sein können.

Weiterhin erkennbar in der Figur sind fest mit der Abbildungsvorrichtung 2 verbundene in der Figur als Stäbe dargestellte Referenzelemente 9, welche durch die Trennwand 11 zwischen den beiden Vakuumkammern 4 und 5 in die Vakuumkammer 5 ragen und welche als Sensortargets 15 ausgebildete Referenzmarken aufweisen, die als spiegelnde Flächen ausgebildet sein können und als Referenzen der Interferometer 7 dienen. Die in dem Interferometer 7 verlaufenden und die Strahlungsfenster 16 durchtretenden, in der Figur durch nicht bezeichneten Doppelpfeile dargestellten Messstrahlen erreichen dabei die Sensortargets 15 des Interferometers 7 und treten nach einer Reflexion an den Sensortargets 15 wieder durch die Strahlungsfenster 16 in einen Sende-/Empfangsteil 10 des Interferometers 7 ein, der beispielsweise eine in der Figur 1 nicht gesondert dargestellte Strahlungsquelle und eine ebenfalls in der Figur 1 nicht dargestellte Empfangsvorrichtung des Interferometers 7 enthalten kann.

Wie die Abbildungsvorrichtung 2 ist auch der Maskenhalter 20 mit Sensortargets 15 versehen, welche ebenfalls zur Reflexion der Messstrahlen des Interferometers 7 dienen. Dadurch wird es möglich, die Relativposition des Maskenhalters 20 (und damit der Maske 1) und der Abbildungsvorrichtung 2 zu bestimmen und gegebenenfalls zu regeln.

Eine ebenfalls vorliegend nicht beanspruchte Alternative zu der in Figur 1 gezeigten Anordnung findet sich in Figur 2. Dort ist ein Teilbereich des Interferometers 7 mit der Abbildungsvorrichtung 2 fest verbunden und macht deren Bewegungen mit. Auf diese Weise lässt sich die relative Position der Abbildungsvorrichtung 2 zu der Maske 1 vergleichsweise einfach bestimmen.

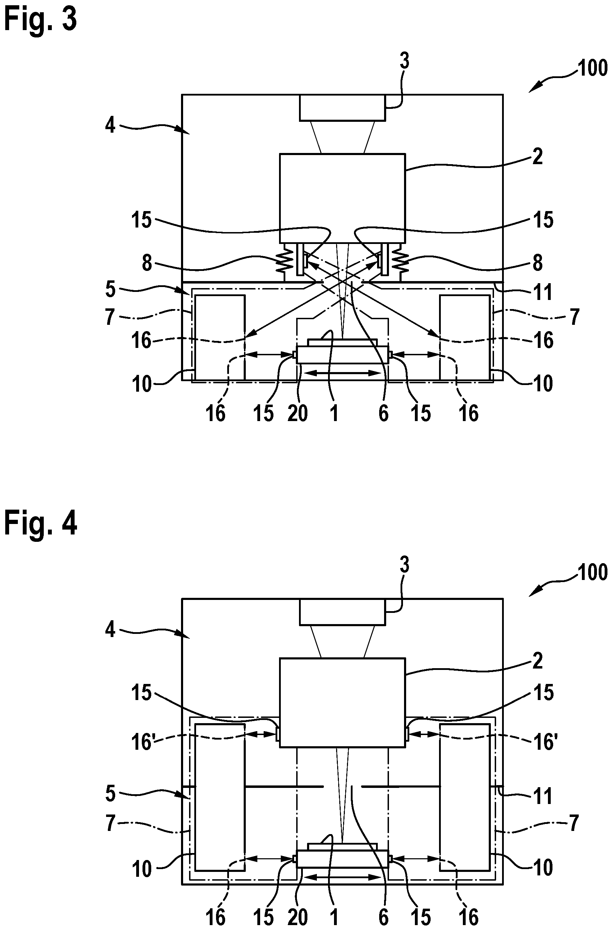

Figur 3 zeigt eine Ausführungsform der Erfindung, bei welcher die Sensortargets 15, welche der Abbildungsvorrichtung 2 zugeordnet sind, sich in derselben Vakuumkammer 4 befinden wie die Abbildungsvorrichtung 2. Dies wird im gezeigten Beispiel dadurch erreicht, dass die Messstrahlen der Interferometer 7 schräg verlaufen und die Öffnung 6 in der Trennwand 11 zwischen den Vakuumkammern 4 und 5 durchtreten, welche auch für die Bildaufnahme durch die Abbildungsvorrichtung 2 genutzt wird. Die Strahlwege der von den Sensortargets 15 ausgehenden bzw. an diesen reflektierten elektromagnetischen Strahlung kreuzen sich also im gezeigten Beispiel. Auch ein windschiefer Verlauf der Strahlwege ist denkbar. Auf diese Weise kann die Öffnung 6 zwischen der Vakuumkammer 4 und der Vakuumkammer 5 vergleichsweise klein gehalten werden. Weiterhin können Sensortargets 15 auf diese Weise näher an der Abbildungsvorrichtung 2 angebracht werden, so dass sich Dynamikvorteile ergeben und eine höhere Performance bei der Regelung der relativen Position von Abbildungsvorrichtung 2 und Maske 1 erreichbar wird.

Insgesamt lässt sich die Konstruktion durch die gezeigten Maßnahmen auch wesentlich kompakter ausführen und ein Tausch der Abbildungsvorrichtung 2 im Feld, also am Einsatzort einer entsprechenden Masseninspektionsvorrichtung 100, wird vereinfacht.

Dadurch, dass die Messstrahlen der Interferometer 7 im gezeigten Beispiel schräg geführt werden, kann es erforderlich sein, eine Zwischenrechnung vorzunehmen, um die korrekte Relativbewegung von Abbildungsvorrichtung 2 und Maske 1 zueinander feststellen zu können.

Figur 4 zeigt eine vorliegend nicht beanspruchte Variante, bei welcher die Interferometer derart ausgebildet sind, dass derjenige Messstrahl, welcher die Abbildungsvorrichtung 2 erreicht, vollständig in der Vakuumkammer 4 verläuft. Dabei sind die Sende-Empfangsteile 10 der Interferometer 7 in die Trennwand 11 eingesetzt und die Strahlungsfenster 16 für den Messstrahl für die Maske 1 sind in der zugehörigen Vakuumkammer 5 angeordnet, wohingegen die Strahlungsfenster 16' für den Messstrahl für die Abbildungsvorrichtung 2 in der zugehörigen Vakuumkammer 4 angeordnet sind. Es kann in diesem Fall erforderlich sein, eine besondere Kapselung der Sende-Empfangsteile 10 der Interferometer 7 vorzunehmen.

### Bezugszeichenliste

- 1: Element, Maske
- 2: Abbildungsvorrichtung
- 3: Bildsensor
- 4: Erstes Teilvolumen
- 5: Zweites Teilvolumen
- 6: Öffnung
- 7: Interferometer
- 8: Entkopplungselement
- 9: Referenzelement
- 10: Sende-/Empfangsteil
- 11: Trennwand
- 15: Referenzmarke, Sensortarget
- 16,16`: Strahlungsfenster
- 100: Optische Inspektionsvorrichtung

## Patentansprüche

1. Optische Inspektionsvorrichtung (100) für Elemente (1) der Halbleiterlithographie,
- mit einer in einem ersten Teilvolumen (4) angeordneten Abbildungsvorrichtung (2) zur Erzeugung eines Bildes eines Elementes und
- einem zweiten Teilvolumen (5), welches eine Haltevorrichtung (20) zur Aufnahme des Elementes (1) umfasst,
- wobei zwischen den beiden Teilvolumina (4,5) ein Trennelement (11) angeordnet ist,
- und mit mindestens einer Positionsmessvorrichtung (7) zur Ermittlung der Position und Ausrichtung der Abbildungsvorrichtung (2) und der Haltevorrichtung (20),
- wobei die Positionsmessvorrichtung (7) Referenzmarken (15) zur Emission einer in der Positionsmessvorrichtung (7) verwendeten elektromagnetischen Strahlung umfasst
- wobei die Referenzmarken (15) jeweils mit der Abbildungsvorrichtung (2) und der Haltevorrichtung (20) verbunden sind,
- wobei das Trennelement (11) eine Trennwand mit einer Öffnung (6) umfasst, wobei die Öffnung (6) zur Bildaufnahme durch die Abbildungsvorrichtung (2) dient und wobei die von der auf der Abbildungsvorrichtung (2) angebrachten Referenzmarke (15) ausgehende und in der Positionsmessvorrichtung (7) verlaufende elektromagnetische Strahlung die Öffnung (6) durchtritt.

2. Optische Inspektionsvorrichtung (100) nach Anspruch 1,
**dadurch gekennzeichnet, dass**
mindestens zwei Positionsmessvorrichtungen (7) und mindestens zwei auf der Abbildungsvorrichtung (2) angebrachte Referenzmarken (15) vorhanden sind, wobei die Strahlwege der von den Referenzmarken (15) ausgehenden und in den Positionsmessvorrichtungen (7) verlaufenden elektromagnetischen Strahlung schräg zu einander verlaufen.

3. Optische Inspektionsvorrichtung (100) nach Anspruch 2,
**dadurch gekennzeichnet, dass**
sich die Strahlwege der von den Referenzmarken (15) ausgehenden und in den Positionsmessvorrichtungen (7) verlaufenden elektromagnetischen Strahlung kreuzen.

4. Optische Inspektionsvorrichtung (100) nach einem der Ansprüche 1 bis 3, **dadurch gekennzeichnet, dass**
es sich bei der optischen Inspektionsvorrichtung (100) um ein Maskeninspektionssystem für Fotomasken der EUV-Lithographie handelt.

5. Optische Inspektionsvorrichtung (100) nach einem der Ansprüche 1 bis 4, **dadurch gekennzeichnet, dass**
es sich bei der Positionsmessvorrichtung (7) um ein Interferometer handelt.
